(19) Europäisches Patentamt
European Patent Office
Office européen des brevets

(11) **EP 2 494 690 B1**

(12) **FASCICULE DE BREVET EUROPEEN**

(45) Date de publication et mention
de la délivrance du brevet:
**30.05.2018 Bulletin 2018/22**

(21) Numéro de dépôt: **10771420.6**

(22) Date de dépôt: **20.10.2010**

(51) Int Cl.:
*H03F 1/32* (2006.01)   *H03F 3/19* (2006.01)
*H03F 3/24* (2006.01)   *H03F 3/68* (2006.01)
*H04B 1/04* (2006.01)

(86) Numéro de dépôt international:
**PCT/EP2010/065775**

(87) Numéro de publication internationale:
**WO 2011/051146 (05.05.2011 Gazette 2011/18)**

(54) **DISPOSITIF D'AMPLIFICATION MULTI-PORTS AUTO COMPENSE EN PRESENCE DE TRANSMISSION DE DONNÉES**

SELBSTKOMPENSIERENDER VERSTÄRKER MIT MEHREREN EINGÄNGEN BEI DATENÜBERTRAGUNG

SELF-COMPENSATING MULTIPORT AMPLIFICATION APPARATUS DURING DATA TRANSMISSION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.10.2009 FR 0905164**

(43) Date de publication de la demande:
**05.09.2012 Bulletin 2012/36**

(73) Titulaire: **THALES**
**92400 Courbevoie (FR)**

(72) Inventeurs:
• **TRONCHE, Christian**
**F-31150 Lespinasse (FR)**
• **SOULIE, Jean-Marc**
**F-12170 Requista (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A1-2009/080752     US-A1- 2002 168 949**
**US-B1- 6 243 038**

**Description**

La présente invention concerne un dispositif d'amplification multi-ports connu sous l'abréviation anglo-saxonne MPA (Multi-Port Amplifier), encore appelé sous-système à amplification répartie. Ce type de dispositif est couramment utilisé dans des systèmes de communication utilisant des antennes multi faisceaux qui ont la capacité de former plusieurs faisceaux d'onde dans différentes directions. En particulier, les systèmes de communication par satellite utilisent ce type d'amplificateur pour répartir de manière flexible plusieurs canaux de transmission vers plusieurs faisceaux de sortie.

Un des paramètres essentiels d'un amplificateur multi-ports est l'isolation entre les différentes voies de sortie qui doit être suffisante pour garantir une isolation acceptable entre les faisceaux générés par l'antenne. L'isolation d'une première voie de sortie vis-à-vis d'une seconde voie de sortie différente de la première se mesure par le rapport entre la puissance maximum du signal amplifié sur la première voie de sortie de l'amplificateur multi-ports et la puissance résiduelle présente sur la seconde voie de sortie de l'amplificateur multi-ports, cette puissance résiduelle étant due aux imperfections du système et également au phénomène d'intermodulation.

Un amplificateur multi-ports théorique possède une isolation infinie entre chacun de ses ports de sortie, cependant dans la pratique, les matrices de Butler et les chaines d'amplification utilisées au sein d'un tel amplificateur ne sont pas idéales et présentent des imperfections qui peuvent engendrer des erreurs d'amplitude et de phase qui ont au final un impact sur l'isolation de chacune des voies de sortie vis-à-vis des autres. Ce phénomène est notamment d'autant plus impactant que la fréquence porteuse utilisée est élevée. Aux vues de ces limitations, il est donc nécessaire de produire une solution permettant de corriger les erreurs d'amplitude et de phase et donc d'améliorer l'isolation globale du système.

Le brevet américain US7088173 décrit une méthode permettant de corriger les imperfections de phase au sein d'un amplificateur multi-ports. La solution envisagée utilise des signaux de test injectés à différents points du réseau d'entrée et mesurés à différents points du réseau de sortie afin de déterminer les erreurs de phase impactant les amplificateurs. Cette solution nécessite de désactiver une partie des amplificateurs pour effectuer les différentes mesures requises. Cette méthode n'est donc pas adaptée à la mise en oeuvre simultanée d'une communication.

Le brevet américain US6006111 et le brevet japonais JP2005269043 décrivent également des procédés permettant de compenser les imperfections d'un système d'amplification répartie à partir de mesures effectuées sur une ou plusieurs voies de sortie mais ces méthodes n'utilisent que la mesure de l'amplitude sans prendre en compte les erreurs de phase.

La demande de brevet internationale WO2008135753 décrit une solution d'amplificateur multi-ports auto-compensé comportant 8 voies d'entrée et 8 voies de sortie. Le principe consiste à injecter un signal de référence sur la première branche d'entrée du dispositif puis de mesurer grâce à 7 détecteurs de puissance répartis dans la matrice de sortie, le déséquilibre entre voies. Plusieurs boucles de contre-réaction agissent ensuite sur les atténuateurs et les déphaseurs placés en amont des amplificateurs afin de minimiser la tension détectée en chacun des 7 points. La méthode décrite dans cette demande de brevet utilise un procédé itératif d'ajustement de l'amplitude et de la phase en amont des amplificateurs pour converger vers une valeur de puissance nulle sur chaque point de la matrice de sortie où est positionné un détecteur de puissance. Ce procédé ne semble pas suffisamment performant pour assurer une isolation suffisante car la matrice d'isolation après compensation apparait dégradée en comparaison à la matrice d'isolation avant compensation. Le résultat obtenu n'est, en particulier, pas compatible du bon fonctionnement d'une mission satellitaire de télécommunications.

On peut citer également la demande de brevet américaine US20080143562 qui propose une méthode de compensation basée sur une connaissance a priori du signal transmis en modélisant sa densité de probabilité. Une telle méthode est trop restrictive car elle n'est pas adaptable à tout type de signal, en particulier un signal modulé par la combinaison de plusieurs modulations simples.

On connait enfin la demande internationale publiée sous le numéro WO 2009/080752 qui traite de l'amélioration de l'isolation entre les différentes voies d'un système d'amplification multi répartie.

Aux vues des limitations de l'art antérieur, la présente invention introduit une solution de système à amplification répartie auto compensé dans le but de minimiser les erreurs d'amplitude et de phase inhérentes aux imperfections d'un tel système. Cette solution permet d'améliorer considérablement les performances d'isolation entre voies de sortie du dispositif et fonctionne en présence de trafic, c'est-à-dire sans interrompre le fonctionnement nominal du système de communication mettant en oeuvre un amplificateur selon l'invention.

A cet effet l'invention a pour objet un système d'amplification multi répartie d'un signal de communication comportant au moins une pluralité N de voies i d'entrée reliées à une matrice de Butler d'entrée apte à délivrer qui délivre en sortie N signaux répartis, une pluralité N d'amplificateurs aptes à recevoir en entrée lesdits signaux répartis et aptes à produire en sortie N signaux amplifiés et déphasés chacun d'un gain complexe $G_i$ et une matrice de Butler de sortie apte à recevoir en entrée lesdits signaux amplifiés et apte à produire en sortie N signaux de sortie, ledit système étant caractérisé en ce qu'il comporte en plus :

◦ un générateur de signal de référence d'amplitude connue et de phase connue, ledit signal de référence étant fourni sur une seule desdites voies d'entrée dudit système, ledit signal de référence étant transmis simultanément audit signal de communication à amplifier,

◦ un dispositif de mesure des erreurs S d'amplitude et de phase de chacun desdits signaux de sortie dudit système, ledit dispositif étant adapté à effectuer une démodulation cohérente du signal amplifié afin d'extraire ledit signal de référence dudit signal de communication et d'estimer lesdites erreurs d'amplitude et de phase impactant le signal de référence,

◦ un dispositif de traitement de signal recevant en entrée lesdites mesures S des erreurs d'amplitude et de phase, et produisant, à partir desdites mesures S, pour chaque voie i dudit système, une compensation en amplitude $a'_i$ et en phase $\Phi'_i$, calculée de sorte à minimiser les différences entre le gain complexe $G_i$ de l'amplificateur de chaque voie i et le gain complexe $G_1$ de l'amplificateur d'une voie de référence parmi les voies dudit système,

◦ un dispositif de compensation en phase/amplitude, inséré entre ladite matrice de Butler d'entrée et la pluralité d'amplificateurs et adapté à corriger chacune des voies i dudit système à partir des valeurs reçues de compensation en amplitude $a'_i$ et en phase $\Phi'_i$.

Dans une variante de réalisation de l'invention, ladite voie de référence est une des voies du système d'amplification ou une voie virtuelle dont le gain est égal à la moyenne des gains de l'ensemble des voies du système d'amplification ou la voie i présentant le gain $G_i$ le plus faible ou la voie i présentant le gain $G_i$ le plus élevé.

Dans une variante de réalisation de l'invention, ledit signal de référence est étalé spectralement à l'aide d'un code d'étalement et ledit dispositif de mesure est adapté, en plus, à désétaler le signal reçu à partir dudit code d'étalement afin de séparer le signal de référence du signal de communication.

Dans une variante de réalisation de l'invention, le dispositif de traitement de signal détermine la compensation en amplitude $a'_i$ et en phase $\Phi'_i$ à partir d'au moins les étapes de calcul suivantes :

◦ une étape de calcul des gains complexes $G_i$ à partir de la relation suivante : $$G_i = \frac{S_1^i}{e.MB_1^i.a_i.e^{j\Phi_i}}$$ , où $S_1^i$ est la composante d'indice i du vecteur $S_1 = MB_2^{-1}.S$ avec $MB_2^{-1}$ l'inverse de la matrice de Butler de sortie, $MB_1^i$ est la composante d'indice i de la première ligne de la matrice de Butler d'entrée, $a_i$ et $\Phi_i$ sont les compensations en amplitude et en phase obtenues à un instant antérieur,

◦ une étape de calcul des quantités suivantes, pour chaque voie d'indice i, $\Delta Z_{1,i} = (a_i+|G_i|)-(a_1+|G_1|)$ et $\Delta\Phi_{1,i} = (\Phi_i+\arg(G_i))-(\Phi_1+\arg(G_1))$, où $|\ |$ désigne le module d'un nombre complexe et $\arg()$ désigne sa phase, l'indice 1 désigne la voie de référence,

◦ une étape de calcul de l'amplitude $OBO_i$ du signal en sortie de chaque amplificateur à partir dudit vecteur $S_1$,

◦ une étape de calcul de la compensation en amplitude $a'_i$, sur chaque voie i, à un instant ultérieur, à partir de ladite quantité $\Delta Z_{1,i}$ et de l'amplitude $OBO_i$ du signal de sortie de l'amplificateur de ladite voie,

◦ une étape de calcul de la compensation en phase $\Phi'_i$ sur chaque voie i, à un instant ultérieur, à partir de la dite quantité $\Delta\Phi_{1,i}$ selon la relation $\Phi'_i = \Phi_i - \Delta\Phi_{1,i}$

Dans une variante de réalisation de l'invention, la compensation en amplitude $a'_i$ est déterminée au moins à l'aide des relations suivantes : $a'_i = a_i+IBO'_i-IBO_i$ où $IBO_i = f_{AM,AM}^i(OBO_i)$, $OBO'_i = OBO_i-\Delta Z_{1,i}$ et $IBO'_i = f_{AM,AM}^i(OBO'_i)$ , avec $f_{AM,AM}^i$ la fonction de transfert de l'amplificateur à tube de la voie i qui relie les amplitudes d'entrée et de sortie,

Dans une autre variante de réalisation de l'invention, la compensation en amplitude $a'_i$ est déterminée au moins à l'aide de la relation suivante : $a'_i = a_i+\eta(OBO'_i-OBO_i)$ avec $\eta$ un coefficient multiplicatif inférieur à 1 en valeur absolue et $OBO'_i = OBO_i - \Delta Z_{1,i}$.

Dans une variante de réalisation de l'invention, la compensation en phase $\Phi'_i$ est déterminée en outre à partir des relations suivantes :

$$\Theta_i = f_{AM,PM}^i(OBO_i)$$

$$\Theta'_i = f^i_{AM,PM}(OBO'_i)$$ où f$^i_{AM,PM}$ est la fonction de transfert de

$$\Phi'_i = \Phi_i - \Delta\Phi_{1,i} - (\Theta'_i - \Theta_i)$$

l'amplificateur à tube de la voie i qui relie la phase d'entrée à l'amplitude de sortie.

Dans une variante de réalisation de l'invention, lesdites matrices de Butler d'entrée et de sortie sont composées d'une pluralité de coupleurs hybrides reliés entre eux.

Dans une variante de réalisation de l'invention, lesdites matrices MB$_1$ et MB$_2$ sont obtenues à partir de mesures des fonctions de transfert des matrices de Butler d'entrée et de sortie ou à partir des fonctions de transfert théoriques des matrices de Butler d'entrée et de sortie.

Dans une variante de réalisation de l'invention, ledit dispositif de mesure est adapté, en plus, à mesurer l'isolation I entre la voie de référence et les autres voies de sortie dudit système et qu'une nouvelle compensation en amplitude a'$_i$ et en phase $\Phi'_i$ est déterminée de façon adaptative dès que la valeur de l'isolation I dépasse un seuil donné.

Dans une variante de réalisation, lesdits amplificateurs sont des amplificateurs à tubes ou des amplificateurs à état solide.

Dans une variante de réalisation, le système selon l'invention est utilisé dans un système de communication par satellite, ledit dispositif de traitement de signal est déporté dans un équipement sol et communique avec ledit système situé dans un équipement bord par le biais d'une liaison de télécommande et/ou d'une liaison de télémesure.

L'invention a également pour objet une utilisation du système selon l'invention pour la détection de défauts des amplificateurs d'une desdites voies i du système caractérisé en ce que les composantes du vecteur $S_1 = MB_2^{-1}.S$ sont comparées à un seuil donné afin de détecter une baisse significative de puissance en sortie d'un desdits amplificateurs et de remplacer l'amplificateur défectueux.

D'autres caractéristiques apparaîtront à la lecture de la description détaillée donnée à titre d'exemple et non limitative qui suit faite en regard de dessins annexés qui représentent :

La figure 1, un synoptique d'un exemple d'amplificateur multi-ports possédant 4 entrée et 4 sorties selon l'art antérieur,
La figure 2, un diagramme représentant le spectre du signal composite injecté en entrée d'un amplificateur multi-ports selon l'invention,
La figure 3, un schéma d'un amplificateur multi-ports auto compensé selon l'invention,
Les figures 3a et 3b, deux schémas d'exemples de mise en oeuvre du dispositif de mesure des erreurs d'amplitude et phase en sortie de l'amplificateur selon l'invention,
Les figures 4a et 4b un diagramme d'un exemple de fonctions de transfert d'un amplificateur à tube,
La figure 5, une illustration des performances obtenues avant et après compensation de l'isolation d'un amplificateur selon l'invention.

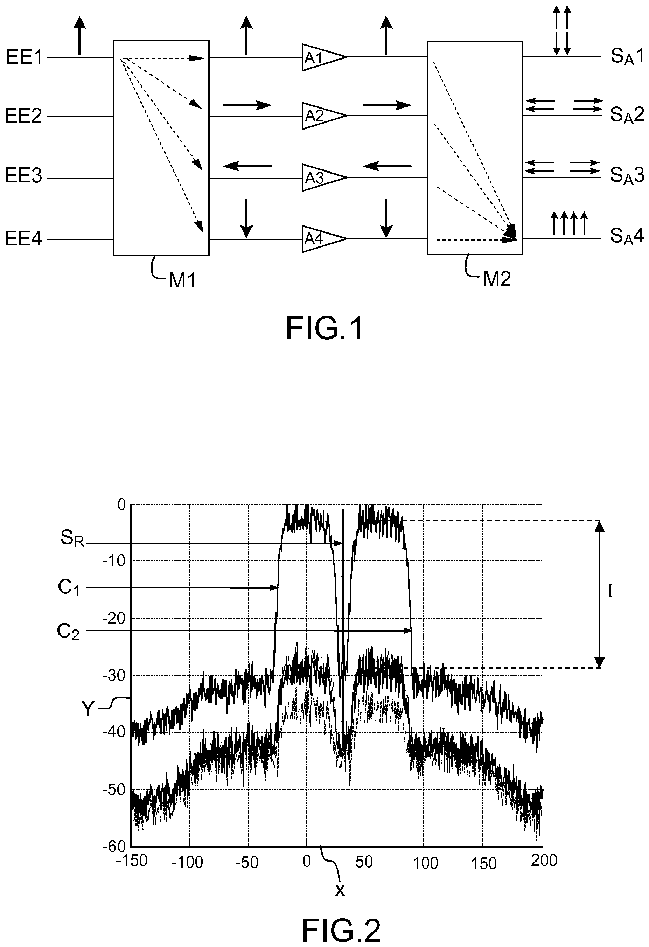

La figure 1 schématise un exemple d'amplificateur multi-ports selon l'art antérieur. Cet amplificateur est composé d'une matrice d'entrée M1 à 4 entrées E1,E2,E3,E4. Ces 4 entrées sont disponibles pour recevoir 4 signaux distincts, par exemple transmis sur 4 canalisations fréquentielles différentes. La matrice d'entrée M1, par exemple une matrice de Butler, comporte typiquement trois séries de quatre coupleurs hybrides mis en cascade. La fonction de la matrice d'entrée M1 est de répartir un signal envoyé par exemple sur l'entrée E1 vers les quatre branches de sortie. Sur chaque sortie de ladite matrice, un déphasage progressif est appliqué. La première sortie n'est pas déphasée, la deuxième sortie est déphasée d'un angle égal à 90°, la troisième sortie est déphasée d'un angle égal à -90° et la dernière sortie est déphasée d'un angle égal à 180°. Les quatre signaux obtenus sur les quatre branches de sortie de la matrice d'entrée M1 sont ensuite amplifiés par l'intermédiaire d'une série d'amplificateurs à tubes A1,A2,A3,A4. Les signaux délivrés par chacun desdits amplificateurs à tubes sont ensuite traités par une matrice de sortie M2 dont la fonction de transfert est identique à celle de la matrice d'entrée M1. En sortie de la matrice M2, quatre signaux amplifiés sont disponibles. Dans le cas où un unique signal est transmis sur l'entrée E1 du dispositif, ce signal se retrouve amplifié d'un facteur quatre sur la voie de sortie S$_A$4, alors que les trois autres voies de sortie S$_A$1, S$_A$2, S$_A$3 délivrent un signal d'amplitude et de phase nulle, du fait des combinaisons des quatre signaux déphasés en sortie de la matrice d'entrée M1.

Ce résultat est obtenu dans le cas d'un amplificateur multi-ports théorique, c'est-à-dire un amplificateur dont tous les éléments qui le composent ne présente aucune imperfection et ont notamment une fonction de transfert rigoureusement identique à celle attendue. Dans ce cas le signal transmis sur la voie d'entrée E1 se retrouve amplifié intégralement sur la voie de sortie S$_A$4 tandis que la puissance délivrée sur les autres voies de sortie est nulle. L'isolation de la voie S$_A$4 vis-à-vis des autres voies est donc infinie.

Dans un cas réel, ni les matrices d'entrée et de sortie, ni les amplificateurs à tubes ne sont idéaux ce qui se traduit par une isolation finie entre les voies de sortie. Afin d'obtenir une isolation suffisante, il est nécessaire de corriger les imperfections des matrices de Butler d'entrée et de sortie ainsi que de minimiser les erreurs d'amplitude et de phase en entrée des amplificateurs à tubes. Ces erreurs sont notamment fonction des effets de la température, de la bande de fréquence utilisée et du vieillissement du dispositif.

La figure 2 illustre un exemple de signal composite utilisé en entrée du dispositif selon l'invention dans le but d'effectuer une compensation des imperfections. Le spectre en fréquence de ce signal est représenté sur un diagramme d'abscisse X représentant les fréquences en MHz et d'ordonnée Y représentant la densité spectrale de puissance en dBm par MHz.

Un des objectifs de l'invention est de compenser l'amplificateur multi-ports sans interruption de la communication. Pour cela, une solution consiste à injecter un signal de référence $S_R$ non modulé et transmis sur une fréquence porteuse unique. La valeur de cette fréquence porteuse est choisie de façon à ce que le signal de référence $S_R$ soit introduit entre deux canaux de communications $C_1$ et $C_2$ sans en altérer les performances. De cette façon la compensation des imperfections du dispositif peut être effectuée en permanence et sans interrompre les communications mises en oeuvre.

Le signal de référence $S_R$ introduit sert à estimer les variations différentielles de phase et d'amplitude afin de les compenser ensuite en amont des amplificateurs à tubes. Sur la figure 2 est également illustrée l'isolation I du signal de communication $C_2$ en sortie du dispositif d'amplification selon l'invention. Une valeur d'isolation I supérieure ou égale à 25 décibels est acceptable pour garantir des performances correctes du dispositif d'amplification notamment lorsqu'il est utilisé dans un système de communication par satellite.

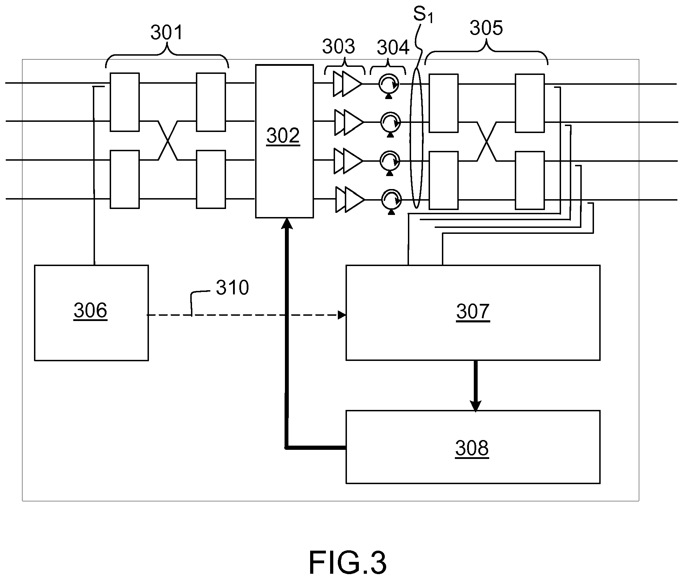

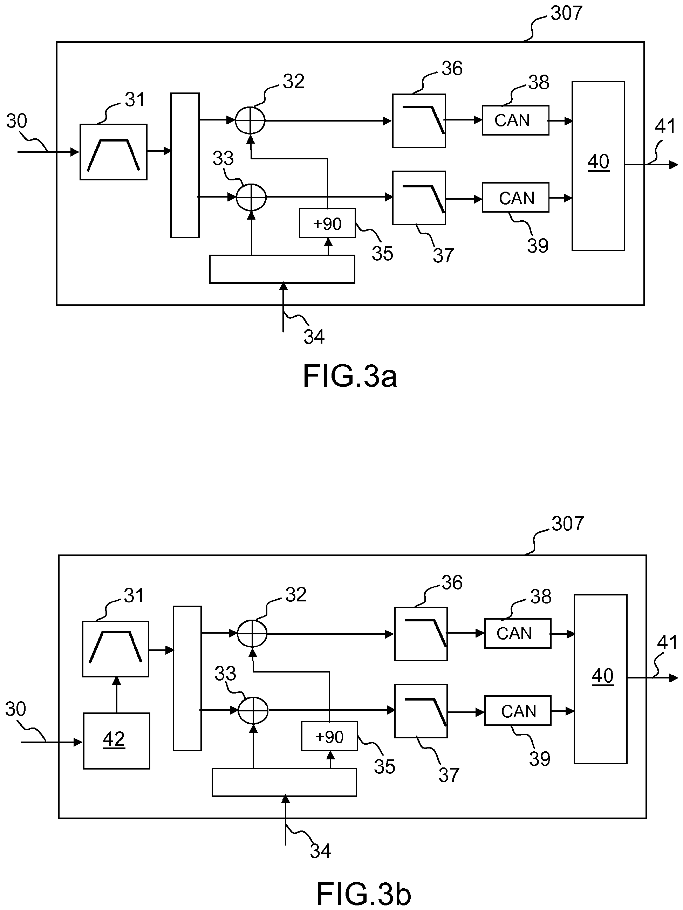

La figure 3 schématise un synoptique d'un amplificateur multi-ports auto compensé selon l'invention. Cet amplificateur est composé d'une matrice d'entrée 301 comportant 4 voies d'entrée et 4 coupleurs hybrides reliés entre eux de façon à représenter une matrice de Butler. Dans un cas plus général, la matrice d'entrée 301 comporte N voies d'entrée et de sortie et (N/2)*M coupleurs hybrides, avec N = $2^M$.

Les sorties de la matrice d'entrée 301 sont reliées à un dispositif 302 de compensation en phase et amplitude composé d'atténuateurs et de déphaseurs et qui est inséré en amont d'une chaine 303 d'amplificateurs à tubes qui ont pour fonction d'amplifier le signal de chaque voie. Chaque amplificateur à tube est relié à un isolateur de puissance 304 qui permet notamment de protéger les amplificateurs à tube 303. Chaque isolateur de puissance 304 est ensuite relié à une des entrées d'une matrice de sortie 305 dont la fonction de transfert est identique à celle de la précédente matrice d'entrée 301. Cette matrice de sortie 305 est également composée de coupleurs hybrides et produit en sortie N signaux amplifiés.

En amont du système, un générateur de signal 306 produit un signal de référence, par exemple un signal à fréquence porteuse pure, qui est transmis sur le premier port d'entrée du dispositif. Les signaux délivrés sur les N voies de sortie sont ensuite extraits par un dispositif de mesure 307 qui sépare le signal de référence des signaux de communication et effectue une estimation de l'erreur d'amplitude et de phase sur le signal de référence et ce pour chacune des voies de sortie. Ces mesures d'erreurs d'amplitude et de phase sont stockées dans une mémoire sous forme matricielle puis un dispositif 308 de traitement de signal exploite ces mesures dans le but de produire une correction en phase et amplitude qui est appliquée rétroactivement par le dispositif de compensation. Le dispositif de mesure est préalablement calibré afin de produire effectivement une erreur de phase et d'amplitude nulles lorsque le signal extrait en sortie est identique au signal de référence généré en entrée.

Dans une variante de réalisation pour laquelle l'amplificateur multi-ports selon l'invention est embarqué à bord d'un satellite en orbite, le dispositif 308 de traitement de signal peut être implémenté dans un équipement au sol. Dans ce cas, les mesures d'erreur d'amplitude et de phase extraites sont transmises au sol par le biais d'une liaison de télémesure descendante, et les corrections générées par le dispositif de traitement de signal sont ensuite transmises à bord du satellite par le biais d'une liaison de télécommande montante.

Dans le cas où le signal de référence injecté en entrée du système est un signal sinusoïdal dont le spectre en fréquence est une fréquence pure tel qu'illustré à la figure 2, le dispositif de mesure 307 a pour fonction la détection d'amplitude et de phase de ce signal de référence qui est transmis simultanément au signal de communication. Une solution possible pour réaliser cette détection d'amplitude et de phase consiste à mettre en oeuvre une démodulation cohérente du signal composite telle que schématisée à l'appui de la figure 3a.

Un vecteur 30 comportant les mesures de signal délivré sur les N voies de sortie de l'amplificateur selon l'invention est fourni en entrée du dispositif de mesure 307. Pour chaque composante du vecteur 30, un filtrage passe-bande 31 est appliqué afin d'extraire le signal de référence du signal utile. Le signal filtré est ensuite corrélé 32,33 avec le signal de référence 34 et le signal de référence déphasé de 90° 35. Les deux signaux corrélés obtenus sont filtrés par le moyen d'un filtre passe bas 36,37 puis une conversion analogique numérique 38,39 est appliquée afin de fournir les voies en phase I et en quadrature Q à un module 40 de calcul qui détermine les erreurs d'amplitude $A = \sqrt{I^2 + Q^2}$

et de phase $\Phi = \arg(\frac{Q}{I})$ pour chacune des voies de sortie de l'amplificateur. Les mesures 41 d'erreur d'amplitude et de phase sont ensuite délivrées au dispositif 308 de traitement de signal.

D'autres mises en oeuvre du dispositif de mesure 307 sont possibles sachant que sa fonction technique consiste à extraire le signal de référence du signal utile puis estimer l'amplitude et la phase qui ont impacté le signal de référence après qu'il est traversé les différents étages qui composent le dispositif d'amplification selon l'invention.

Dans une variante de réalisation de l'invention, le signal de référence 310 est étalé spectralement à l'aide d'un code d'étalement. Dans ce cas, le dispositif de mesure 307 inclus en plus des éléments précédemment décrits un module 42 de désétalement du signal reçu à partir du code d'étalement utilisé qui est fourni par le générateur 306. Un synoptique d'une mise en oeuvre possible d'un tel dispositif 307 est représenté sur la figure 3b. Le désétalement du signal peut se faire par une méthode connue de l'Homme du métier dans le but d'extraire le signal de référence du signal utile, pour ensuite estimer son amplitude et sa phase. L'intérêt de l'utilisation d'un signal à étalement de spectre réside dans le fait qu'un tel signal est plus discret et présente une énergie étalée dans toute la bande de fréquence utilisée.

Une des caractéristiques essentielles de la présente invention réside dans la détermination des corrections 302 en phase et amplitude déterminées par le dispositif 308 de traitement de signal à partir des mesures d'amplitude et de phase obtenues, pour chaque voie de sortie, par le dispositif de mesure 307.

Les éléments constitutifs du système amplificateur selon l'invention peuvent être modélisés à partir des grandeurs suivantes.

La matrice d'entrée 301 est définie par sa réponse matricielle notée MB$_1$. Dans le cas le plus général, la matrice MB$_1$ possède N lignes et N colonnes où N est le nombre de ports d'entrée du système. L'entier N est préférablement égal à une puissance de 2, N = 2$^p$ avec p un entier positif strictement supérieur à 0. Cette matrice est obtenue, par exemple, par mesure.

De façon similaire, la matrice de sortie 305 est définie par sa réponse matricielle MB$_2$ qui possède également N lignes et N colonnes.

Le dispositif 302 de compensation en phase/amplitude est modélisé par la matrice diagonale

$$D_{A-\Phi} = \begin{pmatrix} a_1 e^{j\Phi_1} & 0 & 0 & 0 \\ 0 & a_2 e^{j\Phi_2} & 0 & 0 \\ 0 & 0 & a_3 e^{j\Phi_3} & 0 \\ 0 & 0 & 0 & a_4 e^{j\Phi_4} \end{pmatrix},$$ dans le cas où N= 4, avec $a_i$ la compensation en amplitude et

$\Phi_i$ la compensation en phase appliquée sur chaque voie par le dispositif 302 en amont de la chaine d'amplificateurs 303, i variant de 1 à N.

De façon similaire, l'influence des amplificateurs 303 peut être modélisée à l'aide de la matrice

$$D_{Ampli} = \begin{pmatrix} G_1 & 0 & 0 & 0 \\ 0 & G_2 & 0 & 0 \\ 0 & 0 & G_3 & 0 \\ 0 & 0 & 0 & G_4 \end{pmatrix}$$ dans le cas où N =4, avec $G_i$ le gain de chaque amplificateur pour i variant de 1 à N.

Dans la suite de la description, on fera référence aux différents signaux pris en des points distincts du dispositif à l'aide des notations suivantes. Chaque variable est un vecteur à N composantes qui correspondent chacune au signal sur une des N voies du dispositif. $E = \begin{pmatrix} e \\ 0 \\ 0 \\ 0 \end{pmatrix}$ désigne le signal de référence injecté sur le port numéro 1 d'entrée du

dispositif.

$E_1 = MB_1.E$ désigne le signal obtenu en sortie de la matrice d'entrée 301.

$E_2 = D_{A-\Phi}.MB_1.E$ désigne le signal obtenu en sortie du dispositif 302 de compensation en phase/amplitude.

$S_1 = D_{Ampli}.E_2$ désigne le signal obtenu en sortie de la chaine d'amplificateurs 303 après extraction du signal de référence et du signal utile par le dispositif de mesure 307,

Enfin, $S = MB_2.S_1$ désigne le signal obtenu en sortie de la matrice de sortie 305.

Le dispositif de mesure 307 délivre à sa sortie une mesure de l'amplitude et de la phase du signal de référence sur chaque voie de sortie. Ces mesures permettent de créer le vecteur S.

A partir des relations précédentes, on déduit la relation suivante :

$$S_1 = D_{Ampli} D_{A-\Phi} MB_1 E \quad (1)$$

Avec $S_1 = MB_2^{-1}.S$ Et on en déduit la relation suivante qui relie le vecteur $S_1$ aux autres variables du système.

$$S_1 = \begin{pmatrix} S_1^1 \\ S_1^2 \\ S_1^3 \\ S_1^4 \end{pmatrix} = \begin{pmatrix} e.G_1.a_1 e^{j\Phi_1}.MB_1^{1,1} \\ e.G_2.a_2 e^{j\Phi_2}.MB_1^{2,1} \\ e.G_3.a_3 e^{j\Phi_3}.MB_1^{3,1} \\ e.G_4.a_4 e^{j\Phi_4}.MB_1^{4,1} \end{pmatrix} \quad (2)$$

Où $MB_1^{1,1}$, $MB_1^{2,1}$, $MB_1^{3,1}$, $MB_1^{4,1}$ sont les composantes de la première ligne de la matrice $MB_1$.

Enfin, on arrive à la relation (3) qui permet de déterminer, pour tout i variant de 1 à N (N= 4 dans notre exemple), les gains complexes de chaque amplificateur :

$$G_i = \frac{S_1^i}{e.MB_1^i.a_i.e^{j\Phi_i}} \quad (3)$$

Le vecteur $S_1$ est calculé à partir du vecteur S obtenu par mesures et de la matrice de sortie $MB_2$.

Le signal de référence e est connu de l'utilisateur, ainsi que la matrice d'entrée $MB_1$.

Les valeurs des consignes en amplitude et en phase (matrice $D_{A-\Phi}$) sont initialisées en début de procédé à des valeurs initiales données, $a^0_i$ et $\Phi^0_i$. Le procédé selon l'invention consiste ensuite à déterminer à différents instants d'échantillonnage temporel de nouvelles valeurs $a'_i$ et $\Phi'_i$ de consigne amplitude/phase afin de corriger les défauts d'isolation du système.

Un des objectifs de l'auto compensation en phase et amplitude du système selon l'invention est de corriger les imperfections de la chaine d'amplificateurs modélisée par la matrice $D_{Ampli}$. Pour que le système soit le plus proche de la théorie et que l'isolation entre chaque voie de sortie soit la plus optimale possible, il est nécessaire que chacun des amplificateurs 303 utilisé sur chacune des voies du système présente la même réponse en amplitude et phase. Cette condition est équivalente à une modélisation du système qui satisfait la relation suivante :

$$D_{A-\Phi}.D_{Ampli} = G.I_d \quad (4)$$

Où G est un gain complexe et $I_d$ la matrice identité.

La relation (4) traduit la compensation par le dispositif 302 modélisé par la matrice $D_{A-\Phi}$ des imperfections de la chaine d'amplificateurs 303 modélisée par la matrice $D_{Ampli}$ de façon à obtenir un gain complexe identique sur chaque voie, on parle d'iso-longueur des N chemins composant le dispositif. Pour obtenir ce résultat, il convient dans un premier temps de choisir une voie de référence parmi les N possibles. Par défaut la voie d'indice 1 est prise comme voie de référence, il convient alors de compenser le gain $G_i$ des amplificateurs des N-1 autre voies par la différence de gain $G_1$ entre chaque voie d'indice i et la voie de référence.

La voie de référence peut être prise égale à n'importe quelle voie. La compensation des gains des amplificateurs peut également être effectuée par rapport à une référence virtuelle dont le gain correspond à la moyenne des gains de toutes les voies, au minimum ou au maximum des gains sur l'ensemble des voies.

Pour ce faire, on calcule, pour i variant de 2 à N, les quantités suivantes :

$$\Delta Z_{1,i} = (a_i + |G_i|) - (a_1 + |G_1|) \quad (5)$$

où tous les termes de la relation sont exprimés en décibels, et | | désigne le module d'un nombre complexe, et

$$\Delta\Phi_{1,i} = (\Phi_i + \arg(G_i)) - (\Phi_1 + \arg(G_1)) \quad (6),$$

où tous les termes de la relation sont exprimés en degrés et arg() désigne l'argument d'un nombre complexe.

L'auto-compensation en amplitude/phase du système doit aboutir à un gain complexe, c'est-à-dire une amplitude et une phase, identique sur chaque voie en sortie de la chaine d'amplificateurs 303.

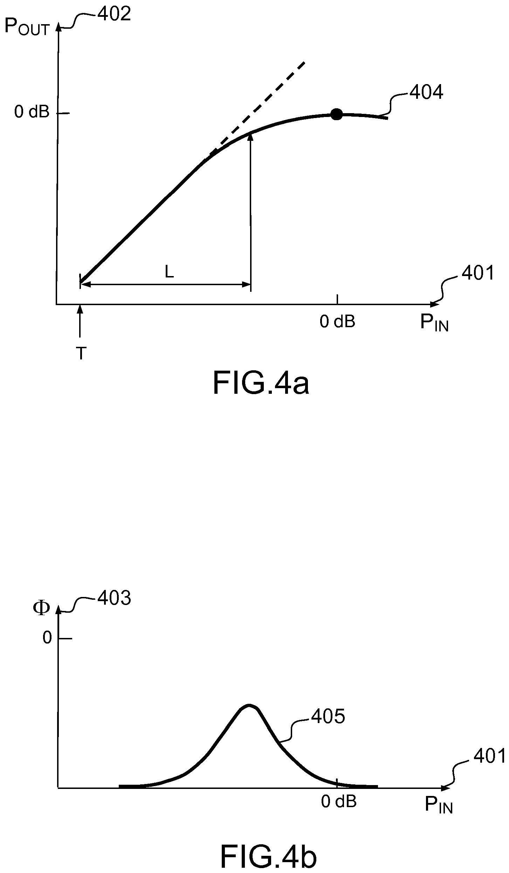

Pour cela, il est nécessaire de prendre en compte la non linéarité desdits amplificateurs. En effet, l'amplitude, respectivement la phase, en sortie d'un amplificateur n'est pas forcément proportionnelle à l'amplitude, respectivement la phase, en entrée du même amplificateur. En pratique un amplificateur i présente une première fonction de transfert $f^i_{AM,AM}$ qui relie l'amplitude du signal d'entrée à l'amplitude du signal de sortie, et une seconde fonction de transfert $f^i_{AM,PM}$ qui relie la phase du signal d'entrée à l'amplitude du signal de sortie. Un exemple de telles fonctions de transfert est illustré à l'appui des figures 4a et 4b. La courbe 404 représente la variation de la puissance du signal de sortie 402 en fonction de celle du signal d'entrée 401. La région L de la courbe 404 est linéaire tandis que le reste de la courbe ne l'est pas. De même la courbe 405 représente la variation de la phase du signal de sortie 403 en fonction de la puissance du signal d'entrée 401.

On introduit ensuite, l'amplitude $IBO_i$ du signal en entrée de l'amplificateur de la voie d'indice i qui est relié à l'amplitude $OBO_i$ du signal en sortie du même amplificateur par la relation suivante :

$$IBO_i = f^i_{AM,AM}(OBO_i) \quad (7)$$

et la phase du signal en entrée du même amplificateur est donnée par la relation :

$$\Theta_i = f^i_{AM,PM}(OBO_i) = \arg(G_i) \quad (8)$$

La valeur du signal en sortie de l'amplificateur est obtenue à partir de la composante i du vecteur $S_1$ précédemment introduit.

On cherche alors à compenser l'amplitude du signal de sortie de chaque amplificateur par la quantité $\Delta Z_{1,i}$ obtenue à la relation (5) de façon à obtenir une nouvelle valeur $OBO'_i = OBO_i - \Delta Z_{1,i}$ de l'amplitude du signal de sortie.

On calcule ensuite les nouvelles amplitudes et phase du signal d'entrée de l'amplificateur à l'aide des relations suivantes :

$$IBO'_i = f^i_{AM,AM}(OBO'_i)$$
$$\Theta'_i = f^i_{AM,PM}(OBO'_i) \quad (9)$$

Enfin la dernière étape de calcul permet d'obtenir les nouvelles valeurs de consigne d'amplitude et de phase que fournit le dispositif de calcul 308 au dispositif de compensation 302 à un instant ultérieur:

$$a'_i = a_i + IBO'_i - IBO_i$$
$$\Phi'_i = \Phi_i - \Delta\Phi_{1,i} - (\Theta'_i - \Theta_i) \quad (10)$$

Dans une variante de réalisation de l'invention, les amplificateurs à tube 303 peuvent être remplacés par des amplificateurs de puissance à état solide, connus sous l'abréviation anglo-saxonne SSPA (Solid State Power Amplifier).

Une autre variante de réalisation de l'invention est à présent décrite pour laquelle la connaissance des matrices d'entrée $MB_1$, de sortie $MB_2$ et la matrice $D_{Ampli}$ modélisant l'influence des amplificateurs 303 n'est pas nécessaire.

En se référant aux relations (1), (2) et (3) ci-dessus introduites, on remarque que le système auto-compensé selon l'invention nécessite la connaissance des matrices $MB_1$ et $MB_2$ ainsi que le calcul (selon la relation (3)) de la matrice $D_{Ampli}$. Cette connaissance a priori implique une mesure, par des moyens externes, des réponses des matrices de Butler d'entrée et de sortie afin de modéliser leur influence réelle qui peut différer des matrices de Butler théoriques du fait des imperfections liées à leur réalisation.

La réponse matricielle réelle $MB_1$ de la matrice de Butler d'entrée peut être décomposée comme le produit de deux termes $MB_1 = M_1^{erreur}$. $MB_1^{th}$, où $MB_1^{th}$ est la matrice de Butler d'entrée théorique et $M_1^{erreur}$ est la matrice diagonale comportant les erreurs ou différences entre la matrice théorique et la matrice réelle. De la même façon on peut écrire pour la matrice de sortie du système $MB_2 = MB_2^{th}$. $M_2^{erreur}$

En prenant en compte les imperfections des matrices de Butler et par un raisonnement analogue à celui décrit précédemment à l'appui de la relation (4), on cherche cette fois à rendre les N chemins traversant les amplificateurs de puissance entre chaque matrice de Butler théorique iso-longueurs. Cette condition est équivalente à une modélisation du système qui satisfait la relation suivante, avec G un gain complexe et $I_d$ la matrice identité :

$$M_2^{erreur} D_{A-\Phi}.D_{Ampli} M_1^{erreur} = G.I_d \quad (11)$$

Les consignes d'amplitude $a_i$ et de phase $\Phi_i$ déterminées par le dispositif de calcul 308 et transmises au dispositif de compensation 302 sont ensuite déterminées de façon analogues au raisonnement décrit précédemment à l'appui des relations (3) et (5) à (10) à l'exception que les termes correctifs $a_i e^{j\Phi i}$ composant la matrice diagonale $D_{A-\Phi}$ intègrent également les imperfections liées aux matrices d'erreurs diagonales $M_1^{erreur}$ et $M_2^{erreur}$. Les relations permettant de déterminer les gains complexes $G_i$ de chaque amplificateur, en particulier la relation (3) et la relation reliant le vecteur intermédiaire $S_1$ et le vecteur de sortie $S$, sont utilisées avec les matrices $MB_1^{th}$ et $MB_2^{th}$ théoriques et non plus réelles.

Dans un autre aspect de l'invention, la prise en compte des caractéristiques $f_{AM,AM}^i$ et $f_{AM,PM}^i$ des amplificateurs de chaque voie n'est plus nécessaire. La compensation en amplitude $a'_i$ est déterminée directement à partir de la valeur d'amplitude de sortie $OBO'_i$ de chaque amplificateur par la relation :

$$a'_i = a_i + \eta(OBO'_i - OBO_i) \quad (12)$$

avec $\eta$ un coefficient multiplicatif inférieur à 1 en valeur absolue.

Cette simplification permet de s'affranchir de la connaissance de la caractéristique précise $f_{AM,AM}^i$ de chaque amplificateur tout en assurant une convergence des calculs vers une valeur limite finie dans un temps raisonnable.

De plus la compensation en phase $\Phi'_i$ peut être déterminée par la relation suivante :

$$\Phi'_i = \Phi_i - \Delta\Phi_{1,i} \quad (13)$$

La correction de phase déterminée selon la relation (13) est intrinsèquement composée de deux termes : une rotation de phase introduite par l'amplificateur à tube et dépendant de sa puissance de sortie $OBO_i$ et un écart de phase dû aux caractéristiques des éléments constituant chaque voie du système MPA. Lors de la première itération de calcul, le second terme est compensé et seul le premier terme évolue au fur et à mesure des itérations. La commande de phase totale, somme des corrections successives appliquées à chaque itération, tend ensuite vers une valeur de plus en plus stable au fur et à mesure de la convergence de la compensation en amplitude. La compensation en phase déterminée selon la relation (13) ne prenant pas en compte la réponse en phase de chaque amplificateur à tubes, cette compensation est imparfaite mais permet tout de même de converger vers une valeur limite dans un temps raisonnable.

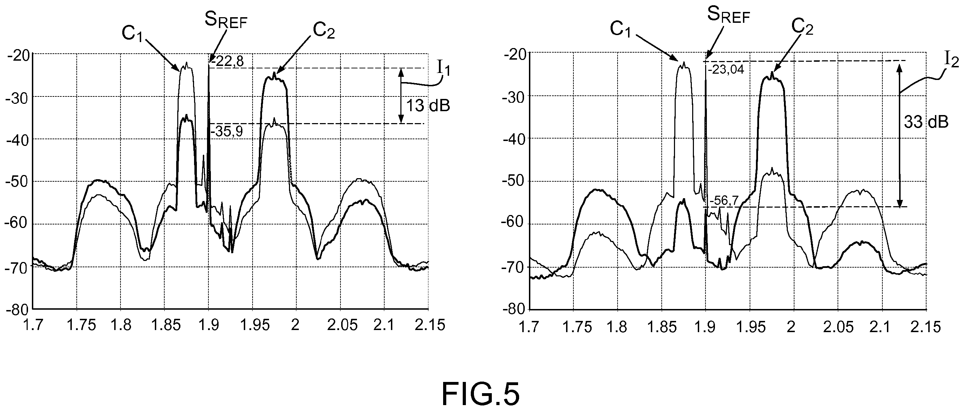

La figure 5 illustre les performances du système auto compensé et le gain obtenu sur l'isolation des voies de sortie. La partie gauche de la figure représente le signal de référence $S_{REF}$, ici un signal de porteuse pure, inséré entre deux signaux de communication $C_1$ et $C_2$. Sur cette figure est représentée l'isolation $I_1$ obtenue entre le signal amplifié sur la voie principale et le résidu présent sur les voies secondaires. L'isolation $I_1$ est de l'ordre de 13 dB. Le même signal composite est représenté sur la partie droite de la figure mais dans le cas où le système a été auto compensé par le procédé selon l'invention décrit précédemment. L'isolation $I_2$ obtenue est améliorée et est cette fois de l'ordre de 33 dB.

Dans une autre variante de réalisation de l'invention, la compensation en phase et amplitude est mise à jour dès que l'isolation I mesurée sur le signal de référence est supérieure à un seuil donné. On parle alors de structure adaptative pour désigner le principe qui consiste à adapter les compensations en phase et amplitude au cours du temps en fonction d'un critère donné. Une compensation adaptative est notamment nécessaire lorsque les erreurs qui impactent le système évoluent au cours du temps en fonction des conditions de fonctionnement. Par opposition, on parle de compensation statique lorsque celle-ci n'est effectuée qu'une fois pour corriger une erreur statique qui n'évolue pas au cours du temps.

Le système d'amplification multi-ports auto compensé selon l'invention présente notamment l'avantage principal d'assurer l'auto compensation en phase et amplitude du système en présence de trafic, c'est-à-dire sans interrompre la transmission. Il est particulièrement adapté aux systèmes de transmission par satellite. En phase d'assemblage, intégration et tests (AIT) l'invention apporte une aide à la recherche des réglages optimaux du système afin de maximiser les performances. En phase de test ou d'exploitation sur orbite (IOT) le dispositif est auto compensé automatiquement par l'intermédiaire de la boucle de compensation qui peut agir depuis un équipement sol vers un équipement bord ou être intégralement située à bord.

Le système d'amplification multi-répartie selon l'invention a comme principal objectif l'autocompensation en amplitude et phase des défauts intrinsèques des composants qui constituent chaque voie d'amplification afin d'assurer une isolation inter voies maximum.

Une autre application du système selon l'invention concerne la détection et localisation d'une panne affectant une chaine d'amplification de puissance sur une des voies du système. En effet, comme explicité précédemment, l'invention permet notamment de déterminer le vecteur $S_1$ composé des puissances des signaux de sortie de chaque chaine d'amplificateurs 303 sur chaque voie. A partir de cette information, un seuil de détection peut être appliqué à chaque puissance du vecteur $S_1$ de façon à déterminer si la puissance de sortie estimée est anormalement faible ce qui résulterait d'un défaut de fonctionnement d'un amplificateur. Le seuil de détection est déterminé en fonction de la puissance du signal émis et du point de fonctionnement visé par l'application.

Lorsqu'une panne est localisée sur une des voies du système d'amplification selon l'invention, une chaine d'amplificateurs 303 peut être remplacée par une chaine redondante prévue à cet effet. Une commutation des entrées et sorties de la chaine d'amplificateurs défectueuse vers la chaine redondante est alors effectuée et un nouveau calcul d'isolation selon l'invention est réalisé.

## Revendications

**1.** Système d'amplification multi répartie d'un signal de communication comportant au moins une pluralité N de voies i d'entrée reliées à une matrice de Butler d'entrée (301) apte à délivrer en sortie N signaux répartis, une pluralité N d'amplificateurs (303) aptes à recevoir en entrée lesdits signaux répartis et aptes à produire en sortie N signaux amplifiés et déphasés chacun d'un gain complexe $G_i$ et une matrice de Butler de sortie (305) apte à recevoir en entrée lesdits signaux amplifiés et apte à produire en sortie N signaux de sortie, ledit système étant **caractérisé en ce qu'**il comporte en plus :

⚬ un générateur (306) de signal de référence d'amplitude connue et de phase connue, ledit signal de référence étant fourni sur une seule desdites voies d'entrée dudit système, ledit signal de référence étant transmis simultanément audit signal de communication à amplifier,
⚬ un dispositif de mesure (307) des erreurs S d'amplitude et de phase de chacun desdits signaux de sortie dudit système, ledit dispositif étant adapté à effectuer une démodulation cohérente du signal amplifié afin d'extraire ledit signal de référence dudit signal de communication et d'estimer lesdites erreurs d'amplitude et de phase impactant le signal de référence,
⚬ un dispositif de traitement de signal (308) recevant en entrée lesdites mesures S des erreurs d'amplitude et de phase, et produisant, à partir desdites mesures S, pour chaque voie i dudit système, une compensation en amplitude $a'_i$ et en phase $\Phi'_i$ calculée de sorte à minimiser les différences entre le gain complexe $G_i$ de l'amplificateur de chaque voie i et le gain complexe $G_1$ de l'amplificateur d'une voie de référence parmi les voies dudit système,
⚬ un dispositif (302) de compensation en phase/amplitude, inséré entre ladite matrice de Butler (301) d'entrée et la pluralité d'amplificateurs (303) et adapté à corriger chacune des voies i dudit système à partir des valeurs reçues de compensation en amplitude $a'_i$ et en phase $\Phi'_i$.

**2.** Système selon la revendication 1 **caractérisé en ce que** ladite voie de référence est une des voies du système d'amplification ou une voie virtuelle dont le gain est égal à la moyenne des gains de l'ensemble des voies du système d'amplification ou la voie i présentant le gain $G_i$ le plus faible ou la voie i présentant le gain $G_i$ le plus élevé.

**3.** Système selon l'une des revendications précédentes **caractérisé en ce que** ledit signal de référence est étalé spectralement à l'aide d'un code d'étalement et ledit dispositif de mesure (307) est adapté, en plus, à désétaler le signal reçu à partir dudit code d'étalement afin de séparer le signal de référence du signal de communication.

4. Système selon l'une des revendications précédentes **caractérisé en ce que** le dispositif de traitement de signal (308) détermine la compensation en amplitude a'$_i$ et en phase $\Phi'_i$ à partir d'au moins les étapes de calcul suivantes :

○ une étape de calcul des gains complexes G$_i$ à partir de la relation suivante : $G_i = \dfrac{S_1^i}{e.MB_1^i.a_i.e^{j\Phi_i}}$ , où

S$^i_1$ est la composante d'indice i du vecteur $S_1 = MB_2^{-1}.S$ avec MB$^{-1}_2$ l'inverse de la matrice de Butler de sortie (305), MB$^i_1$ est la composante d'indice i de la première ligne de la matrice de Butler d'entrée (301), a$_i$ et $\Phi_i$ sont les compensations en amplitude et en phase obtenues à un instant antérieur,
○ une étape de calcul des quantités suivantes, pour chaque voie d'indice i, $\Delta Z_{1,i} = (a_i+|G_i|)-(a_1+|G_1|)$ et $\Delta \Phi_{1,i} = (\Phi_i+\arg(G_i))-(\Phi_1+\arg(G_1))$, où $|\,|$ désigne le module d'un nombre complexe et $\arg()$ désigne sa phase, l'indice 1 désigne la voie de référence,
○ une étape de calcul de l'amplitude OBO$_i$ du signal en sortie de chaque amplificateur à partir dudit vecteur S$_1$,
○ une étape de calcul de la compensation en amplitude a'$_i$ sur chaque voie i, à un instant ultérieur, à partir de ladite quantité $\Delta Z_{1,i}$ et de l'amplitude OBO$_i$ du signal de sortie de l'amplificateur de ladite voie,
○ une étape de calcul de la compensation en phase $\Phi'_i$ sur chaque voie i, à un instant ultérieur, à partir de la dite quantité $\Delta \Phi_{1,i}$ selon la relation $\Phi'_i = \Phi_i - \Delta \Phi_{1,i}$

5. Système selon l'une des revendications 1 à 3 **caractérisé en ce que** la compensation en amplitude a'$_i$ est déterminée au moins à l'aide des relations suivantes: $a'_i = a_z + IBO'_i - IBO_i$ où $IBO_i = f^i_{AM,AM}(OBO_i)$, $OBO'_i = OBO_i - \Delta Z_{1,i}$ et $IBO'_i = f^i_{AM,AM}(OBO'_i)$, avec f$^i_{AM,AM}$ la fonction de transfert de l'amplificateur à tube de la voie i qui relie les amplitudes d'entrée et de sortie,

6. Système selon l'une des revendications 1 à 3 **caractérisé en ce que** la compensation en amplitude a'$_i$ est déterminée au moins à l'aide de la relation suivante: $a'_i = a_i+\eta(OBO'_i-OBO_i)$ avec $\eta$ un coefficient multiplicatif inférieur à 1 en valeur absolue et $OBO'_i = OBO_i - \Delta Z_{1,i}$.

7. Système selon l'une des revendications 1 à 3 **caractérisé en ce que** la compensation en phase $\Phi'_i$ est déterminée en outre à partir des relations

$$\Theta_i = f^i_{AM,PM}(OBO_i)$$

suivantes : $\Theta'_i = f^i_{AM,PM}(OBO'_i)$ où f$^i_{AM,PM}$ est la fonction de transfert

$$\Phi'_i = \Phi_i - \Delta \Phi_{1,i} - (\Theta'_i - \Theta_i)$$

de l'amplificateur à tube de la voie i qui relie la phase d'entrée à l'amplitude de sortie.

8. Système selon l'une des revendications précédentes **caractérisé en ce que** lesdites matrices de Butler d'entrée (301) et de sortie (305) sont composées d'une pluralité de coupleurs hybrides reliés entre eux.

9. Système selon l'une des revendications précédentes **caractérisé en ce que** lesdites matrices MB$_1$ et MB$_2$ sont obtenues à partir de mesures des fonctions de transfert des matrices de Butler d'entrée (301) et de sortie (305) ou à partir des fonctions de transfert théoriques des matrices de Butler d'entrée (301) et de sortie (305).

10. Système selon l'une des revendications précédentes **caractérisé en ce que** ledit dispositif de mesure (307) est adapté, en plus, à mesurer l'isolation I entre la voie de référence et les autres voies de sortie dudit système et qu'une nouvelle compensation en amplitude a'$_i$ et en phase $\Phi'_i$ est déterminée de façon adaptative dès que la valeur de l'isolation I dépasse un seuil donné.

**11.** Système selon l'une des revendications précédentes **caractérisé en ce que** lesdits amplificateurs (303) sont des amplificateurs à tubes ou des amplificateurs à état solide.

**12.** Système selon l'une des revendications précédentes pour utilisation dans un système de communication par satellite **caractérisé en ce que** ledit dispositif de traitement de signal (308) est déporté dans un équipement sol et communique avec ledit système situé dans un équipement bord par le biais d'une liaison de télécommande et/ou d'une liaison de télémesure.

**13.** Utilisation du système selon l'une des revendications précédentes pour la détection de défauts des amplificateurs (303) d'une desdites voies i du système **caractérisé en ce que** les composantes du vecteur $S_1 = MB_2^{-1}.S$ sont comparées à un seuil donné afin de détecter une baisse significative de puissance en sortie d'un desdits amplificateurs (303) et de remplacer l'amplificateur défectueux.

**Patentansprüche**

**1.** System zum mehrfach verteilten Verstärken eines Kommunikationssignals, umfassend wenigstens eine Mehrzahl N von Eingangskanälen i, die mit einer Butler-Eingangsmatrix (301) verbunden sind, die am Ausgang N verteilte Signale liefern kann, wobei eine Mehrzahl N von Verstärkern (303) am Eingang die verteilten Signale empfangen und am Ausgang N verstärkte und phasenverschobene Signale jeweils mit einem komplexen Gewinn $G_i$ erzeugen kann, und einer Butler-Ausgangsmatrix (305), die am Eingang die verstärkten Signale empfangen und am Ausgang N Ausgangssignale produzieren kann, wobei das System **dadurch gekennzeichnet ist, dass** es ferner Folgendes umfasst:

  ◦ einen Generator (306) für ein Referenzsignal von bekannter Amplitude und bekannter Phase, wobei das Referenzsignal auf einem einzigen der Eingangskanäle des Systems geliefert wird, wobei das Referenzsignal gleichzeitig mit dem zu verstärkenden Kommunikationssignal gesendet wird,
  ◦ eine Vorrichtung (307) zum Messen von Amplituden- und Phasenfehlern S von jedem der Ausgangssignale des Systems, wobei die Vorrichtung zum Bewirken einer kohärenten Demodulation des verstärkten Signals ausgelegt ist, um das Referenzsignal des Kommunikationssignals zu extrahieren und die Amplituden- und Phasenfehler zu schätzen, die das Referenzsignal beeinflussen,
  ◦ eine Signalverarbeitungsvorrichtung (308), die am Eingang die Messwerte S von Amplituden- und Phasenfehlern empfängt und auf der Basis der Messwerte S, für jeden Kanal i des Systems, eine Kompensation von Amplitude a'$_i$ und Phase Φ'$_i$ produziert, so berechnet, dass die Differenzen zwischen dem komplexen Gewinn $G_i$ des Verstärkers jedes Kanals i und dem komplexen Gewinn $G_1$ des Verstärkers eines Referenzkanals unter den Kanälen des Systems minimiert werden,
  ◦ eine Vorrichtung (302) zum Kompensieren von Phase/Amplitude, eingefügt zwischen der Butler-Eingangsmatrix (301) und den mehreren Verstärkern (303) und ausgelegt zum Korrigieren jedes der Kanäle i des Systems auf der Basis der empfangenen Kompensationswerte von Amplitude a'$_i$ und Phase Φ'$_i$.

**2.** System nach Anspruch 1, **dadurch gekennzeichnet, dass** der Referenzkanal einer der Kanäle des Verstärkungssystems oder ein virtueller Kanal ist, dessen Gewinn gleich dem Mittel der Gewinne aller Kanäle des Verstärkungssystems ist, oder wobei Kanal i den geringsten Gewinn $G_i$ präsentiert oder Kanal i den höchsten Gewinn $G_i$ präsentiert.

**3.** System nach einem der vorherigen Ansprüche, **dadurch gekennzeichnet, dass** das Referenzsignal mit Hilfe eines Spreizcodes spektrum-gespreizt wird und die Messvorrichtung (307) ferner zum Entspreizen des empfangenen Signals auf der Basis des Spreizcodes ausgelegt ist, um das Referenzsignal vom Kommunikationssignal zu trennen.

**4.** System nach einem der vorherigen Ansprüche, **dadurch gekennzeichnet, dass** die Signalverarbeitungsvorrichtung (308) die Kompensation von Amplitude a'$_i$ und Phase Φ'$_i$ auf der Basis von wenigstens einem der folgenden Rechenschritte bestimmt:

  ◦ einem Schritt des Berechnens von komplexen Gewinnen $G_i$ auf der Basis der folgenden Relation:

$$G_i = \frac{S_1^i}{e.MB_1^i.a_i.e^{j\Phi_i}},$$ wobei $S_1^i$ die Komponente von Index i des Vektors $S_1 = MB_2^{-1}.S$ ist, wobei MB$^{-1}_2$

die Umkehr der Butler-Ausgangsmatrix (305) ist, MB$^1_1$ die Komponente von Index i der ersten Zeile der Butler-Eingangsmatrix (301) ist $a_i$ und $\Phi_i$ die Kompensationen von Amplitude und Phase sind, erhalten zu einem früheren Zeitpunkt,

◦ einen Schritt des Berechnens der folgenden Quantitäten für jeden Indexkanal i: $\Delta Z_{1,i} = (a_i+|G_i|)-(a_1+|G_1|)$ und $\Delta\Phi_{1,i} = (\Phi_i+\arg(G_i))-(\Phi_1+\arg(G_1))$, wobei $|\ |$ das Modul einer komplexen Zahl bezeichnet und arg() seine Phase bezeichnet, der Index 1 den Referenzkanal bezeichnet,

◦ einen Schritt des Berechnens der Amplitude OBO$_i$ des Signals am Ausgang jedes Verstärkers auf der Basis des Vektors $S_1$,

◦ einen Schritt des Berechnens der Kompensation von Amplitude a'auf jedem Kanal i zu einem späteren Zeitpunkt auf der Basis der Quantität $\Delta Z_{1,i}$ und der Amplitude OBO$_i$ des Ausgangssignals des Verstärkers des Kanals,

◦ einen Schritt des Berechnens der Kompensation von Phase $\Phi'_i$ auf jedem Kanal i zu einem späteren Zeitpunkt auf der Basis der Quantität $\Delta\Phi_{1,i}$ gemäß der Relation $\Phi'_i = \Phi_i - \Delta\Phi_{1,i}$.

5. System nach einem der Ansprüche 1 bis 3, **dadurch gekennzeichnet, dass** die Kompensation von Amplitude a'$_i$ mit Hilfe von wenigstens den folgenden Relationen bestimmt wird: $a'_i = a_i + IBO'_i-IBO_i$, wobei

$$IBO_i = f_{AM,AM}^i(OBO_i),\ OBO'_i = OBO_i - \Delta Z_{1,i}\ \text{und}\ IBO'_i = f_{AM,AM}^i(OBO'_i),$$ wobei f$^1$$_{AM,AM}$ die Funktion der Übertragung des Röhrenverstärkers von Kanal i ist, der mit den Ein- und Ausgangsamplituden verbunden ist.

6. System nach einem der Ansprüche 1 bis 3, **dadurch gekennzeichnet, dass** die Kompensation von Amplitude a'$_i$ mit Hilfe von wenigstens der folgenden Relation bestimmt wird: $a'_i = a_i+\eta(OBO'_i-OBO_i)$, wobei $\eta$ ein Multiplikationskoeffizient kleiner als 1 in absolutem Wert und $OBO'_i = OBO_i - \Delta Z_{1,i}$ ist.

7. System nach einem der Ansprüche 1 bis 3, **dadurch gekennzeichnet, dass** die Kompensation der Phase $\Phi'_i$ ferner auf der Basis der folgenden Gleichungen bestimmt

$$\Theta_i = f_{AM,PM}^i(OBO_i)$$

$$\Theta'_i = f_{AM,PM}^i(OBO'_i)$$

wird: $\Phi'_i = \Phi_i - \Delta\Phi_{1,i} - (\Theta'_i-\Theta_i)$, wobei f$^i$$_{AM,PM}$ die Übertragungsfunktion des Röhrenverstärkers des Kanals i ist, der die Eingangsphase mit der Ausgangsamplitude verbindet.

8. System nach einem der vorherigen Ansprüche, **dadurch gekennzeichnet, dass** die Butler-Eingangsmatrizen (301) und Ausgangsmatrizen (305) aus mehreren untereinander verbundenen hybriden Kopplern zusammengesetzt sind.

9. System nach einem der vorherigen Ansprüche, **dadurch gekennzeichnet, dass** die Matrizen MB$_1$ und MB$_2$ auf der Basis von Messwerten der Übertragungsfunktionen der Butler-Eingangs- (301) und -Ausgangsmatrize (305) oder auf der Basis der theoretischen Übertragungsfunktionen der Butler-Eingangs- (301) und -Ausgangsmatrize (305) erhalten werden.

10. System nach einem der vorherigen Ansprüche, **dadurch gekennzeichnet, dass** die Messvorrichtung (307) ferner zum Messen der Isolation I zwischen dem Referenzkanal und den anderen Ausgangskanälen des Systems ausgelegt ist und dass eine neue Kompensation von Amplitude a'$_i$ und Phase $\Phi'_i$ auf adaptive Weise bestimmt wird, sobald der Wert der Isolation I eine gegebene Schwelle übersteigt.

11. System nach einem der vorherigen Ansprüche, **dadurch gekennzeichnet, dass** die Verstärker (303) Röhrenverstärker oder Festkörperverstärker sind.

12. System nach einem der vorherigen Ansprüche zur Nutzung in einem Satellitenkommunikationssystem, **dadurch gekennzeichnet, dass** die Signalverarbeitungsvorrichtung (308) in einer Bodenausrüstung deportiert wird und mit dem System kommuniziert, das sich in einer Bordausrüstung befindet, mittels einer Fernsteuerungsverbindung und/oder einer Fernmessverbindung.

**13.** Verwendung des Systems nach einem der vorherigen Ansprüche zum Erkennen von Fehlern von Verstärkern (303) von einem der Kanäle i des Systems, **dadurch gekennzeichnet, dass** die Komponenten des Vektors $S_1 = MB_2^{-1}.S$ mit einer gegebenen Schwelle verglichen werden, um eine signifikante Leistungsverringerung am Ausgang von einem der Verstärker (303) zu erkennen und den defekten Verstärker auszutauschen.

**Claims**

**1.** System for the multi-distributed amplification of a communication signal comprising at least a plurality N of input channels i connected to an input Butler matrix (301) capable of delivering at the output N distributed signals, a plurality N of amplifiers (303) capable of receiving at the input said distributed signals and capable of producing at the output N amplified and phase-shifted signals each of a complex gain $G_i$ and an output Butler matrix (305) capable of receiving at the input said amplified signals and capable of producing at the output N output signals, said system being **characterised in that** it also comprises:

◦ a generator (306) of reference signal of known amplitude and known phase, said reference signal being provided on a single one of said input channels of said system, said reference signal being transmitted simultaneously with said communication signal to be amplified,
◦ a measuring device (307) for errors S of amplitude and phase of each of said output signals of said system, said device being capable of performing a coherent demodulation of the amplified signal in order to extract said reference signal from said communication signal and estimate said amplitude and phase errors impacting the reference signal,
◦ a signal processing device (308) receiving at the input said amplitude and phase error measurements S, and producing, on the basis of said measurements S, for each channel i of said system, an amplitude $a'_i$ and phase $\Phi'_i$ compensation calculated so as to minimise the differences between the complex gain $G_i$ of the amplifier of each channel i and the complex gain $G_1$ of the amplifier of a reference channel from among the channels of said system,
◦ a phase/amplitude compensating device (302), inserted between said input Butler matrix (301) and the plurality of amplifiers (303) and adapted to correct each of the channels i of said system on the basis of the received values of the amplitude $a'_i$ and phase $\Phi'_i$ compensation.

**2.** System according to claim 1 **characterised in that** said reference channel is one of the channels of the amplification system or a virtual channel of which the gain is equal to the average of the gains of the entirety of the channels of the amplification system or the channel i presenting the lowest gain $G_i$ or the channel i presenting the highest gain $G_i$.

**3.** System according to one of the previous claims **characterised in that** said reference signal is spread spectrally by means of a spreading code and said measuring device (307) is adapted, in addition, to despread the received signal on the basis of said spreading code in order to separate the reference signal from the communication signal.

**4.** System according to one of the previous claims **characterised in that** the signal processing device (308) determines the amplitude $a'_i$ and phase $\Phi'_i$ compensation on the basis of at least the following calculation steps:

◦ a step calculating the complex gains $G_i$ on the basis of the following relation: $G_i = \dfrac{S_1^i}{e.MB_1^i.a_i.e^{j\Phi_i}}$ where

$S_1^i$ is the component of the index i of the vector $S_1 = MB_2^{-1}.S$ with $MB^{-1}_2$ the inverse of the output Butler matrix (305), $MB_1^i$ is the component of the index i of the first row of the input Butler matrix (301), $a_i$ and $\Phi_i$ are the amplitude and phase compensations obtained at an earlier instant,
◦ a step calculating the following quantities, for each channel of index i, $\Delta Z_{1,i} = (a_i+|G_i|)-(a_1+|G_1|)$ and $\Delta\Phi_{1,i} = (\Phi_i+\arg(G_i))-(\Phi_1+\arg(G_1))$ where $|\ |$ refers to the modulus of a complex number and $\arg()$ refers to its phase, the index 1 refers to the reference channel,
◦ a step calculating the amplitude $OBO_i$ of the signal at the output of each amplifier on the basis of said vector $S_1$,
◦ a step calculating the amplitude compensation $a'_i$, on each channel i, at a later instant, on the basis of said

quantity $\Delta Z_{1,i}$ and of the amplitude $OBO_i$ of the output signal of the amplifier of said channel,
◦ a step calculating the phase compensation $\Phi'_i$ on each channel i, at a later instant, on the basis of said quantity $\Delta\Phi_{1,i}$ according to the relation $\Phi'_i = \Phi_i - \Delta\Phi_{1,i}$.

5. System according to one of claims 1 to 3 **characterised in that** the amplitude compensation $a'_i$ is determined at least by means of the following relations: $a'_i = a_i + IBO'_i\text{-}IBO_i$ where $IBO_i = f^i_{AM,AM}(OBO_i)$, $OBO'_i = OBO_i - \Delta Z_{1,i}$ and $IBO'_i = f^i_{AM,AM}(OBO'_i)$, with $f^i_{AM,AM}$ the transfer function of the tube amplifier of the channel i which connects the input and output amplitudes.

6. System according to one of claims 1 to 3 **characterised in that** the amplitude compensation $a'_i$ is determined at least by means of the following relation: $a'_i = a_i + \eta(OBO'_i\text{-}OBO_i)$ with $\eta$ a multiplicative coefficient less than 1 in absolute value and $OBO'_i = OBO_i - \Delta Z_{1,i}$.

7. System according to one of claims 1 to 3 **characterised in that** the phase compensation $\Phi'_i$ is further determined on the basis of the following relations:

$$\Theta_i = f^i_{AM,PM}(OBO_i)$$

$$\Theta'_i = f^i_{AM,PM}(OBO'_i)$$

$\Phi'_i = \Phi_i - \Delta\Phi_{1,i} - (\Theta'_i\text{-}\Theta_i)$ where $f^i_{AM,PM}$ is the transfer function of the tube amplifier of the channel i which connects the input phase to the output amplitude.

8. System according to one of the previous claims **characterised in that** said input (301) and output (305) Butler matrices are composed of a plurality of interconnected hybrid couplers therebetween.

9. System according to one of the previous claims **characterised in that** said matrices $MB_1$ and $MB_2$ are obtained on the basis of the measurements of the transfer functions of the input (301) and output (305) Butler matrices or on the basis of the theoretical transfer functions of the input (301) and output (305) Butler matrices.

10. System according to one of the previous claims **characterised in that** said measuring device (307) is adapted, in addition, to measuring the isolation I between the reference channel and the other output channels of said system and that a new amplitude $a'_i$ and phase $\Phi'_i$ compensation is determined adaptively as soon as the isolation value I passes a given threshold.

11. System according to one of the previous claims **characterised in that** said amplifiers (303) are tube amplifiers or solid-state amplifiers.

12. System according to one of the previous claims for use in a satellite communication system **characterised in that** said signal processing device (308) is remotely sited in ground equipment and communicates with said system situated in onboard equipment by means of a remote control link and/or a telemetry link.

13. Use of the system according to one of the previous claims for detecting faults in the amplifiers (303) of one of said channels i of the system **characterised in that** the components of the vector $S_1 = MB_2^{-1}.S$ are compared to a given threshold in order to detect a significant decline in power at the output of one of said amplifiers (303) and to replace the faulty amplifier.

FIG.1

FIG.2

FIG.3

FIG.3a

FIG.3b

FIG.4a

FIG.4b

FIG.5

EP 2 494 690 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7088173 B
- US 6006111 A
- JP 2005269043 B

- WO 2008135753 A
- US 20080143562 A
- WO 2009080752 A